Europäisches Patentamt

European Patent Office

Office européen des brevets

(11) Veröffentlichungsnummer: **0 287 053 B1**

(19)

# EUROPÄISCHE PATENTSCHRIFT

(12)

(45) Veröffentlichungstag der Patentschrift: **08.04.92**

(51) Int. Cl.⁵: **H03B 21/00**, H03K 23/66

(21) Anmeldenummer: **88105864.8**

(22) Anmeldetag: **13.04.88**

(54) Verfahren und Schaltungsanordnung zur digitalen Einstellung einer Steuerfrequenz.

(30) Priorität: **16.04.87 DE 3712975**

(43) Veröffentlichungstag der Anmeldung:
**19.10.88 Patentblatt 88/42**

(45) Bekanntmachung des Hinweises auf die
Patenterteilung:
**08.04.92 Patentblatt 92/15**

(84) Benannte Vertragsstaaten:
**AT BE CH DE ES FR GB GR IT LI LU NL SE**

(56) Entgegenhaltungen:
**US-A- 4 658 406**

(73) Patentinhaber: **Forschungszentrum Jülich
GmbH
Postfach 1913
W-5170 Jülich(DE)**

(72) Erfinder: **Räbiger, Jürgen
Veldener Strasse 81
W-5160 Düren(DE)**

EP 0 287 053 B1

## Beschreibung

Die Erfindung bezieht sich auf eine Schaltungsanordnung zur digitalen Einstellung einer Steuerfrequenz durchz ganzzahliges Unterteilen eines Frequenznormals, insbesondere eines durch Erregung eines Schwingquarzes erzeugten Frequenznormals. Als Dokument zum Stand der Technik wurde die US-A-4.658.406 berücksichtigt.

Um exakte Steuerfrequenzen zu erhalten, lassen sich für die Mikroprozessortechnik entwickelte Teiler-IC's einsetzen, deren Grenzfrequenz für viele Anwendungsfälle jedoch noch nicht hoch genug ist. Für die Teiler-IC's sind als Frequenznormal Schwingquarze mit Quarzfrequenzen um 9 Mhz geeignet. Diese Frequenzen genügen jedoch in vielen Fällen nicht zur Erzeugung ausreichender Zwischenfrequenzen, beispielsweise um eine erforderliche feinstufige Drehzahleinstellung insbesondere bei Synchronantrieben zu erreichen. So ergibt sich ausgehend von einem üblichen Frequenznormal von 9 Mhz als Primärfrequenz und einem ganzzahligen Divisor von 1500 bei einer Änderung um 1 in digitaler Zählweise eine sprunghafte Steuerfrequenzänderung $\Delta f$ von 4 Hz. Ein solcher Frequenzsprung führt aber bei der Steuerung von Synchronmotoren mindestens vorrübergehend zum Vorlust der Synchronbedingungen und zu erheblichen Phasenstromschwankungen.

Diese Probleme werden durch Anwendung von Ultrahochfrequenztechnik im 100-Mhz-Bereich dadurch umgangen, daß von mindestens um eine Zehnerpotenz höheren Frequenznormalen als Primärfrequenz ausgegangen wird, wobei es dann allerdings erforderlich ist, besonders aufwendige mikroelektronische Module zur Frequenztransformation einzusetzen.

Eine andere Möglichkeit, feinstufige Steuerfrequenzen zu erzeugen, ist mit Hilfe eines Synthezisers möglich. Mit einem Syntheziser lassen sich beispielsweise zwei Frequenzen, die durch ganzzahlige Teilung eines Frequenznormals erhalten werden, durch Addition oder Subtraktion miteinander mischen. Die Verwendung von Synthezisern ist jedoch sehr aufwendig. Denn bei Einsatz eines solchen Gerätes nur für eine derartige Mischaufgabe bleiben viele Eigenschaften des qualitativ hochwertigen Gerätes ungenutzt. Darüberhinaus ist auch ein Synchronmotor, der zusammen mit weiteren Motoren als Antriebskaskade geschaltet ist (beispielsweise bei Fördersystemen zum Gleichlauf des Fördergutes: Papierherstellung, Druckwalzen, Spinnmaschinen), über spezielle Phasendifferenzen nicht steuerbar. Für einen Gleichlauf der Antriebskaskade sind zusätzliche Regelgeräte notwendig.

Aufgabe der Erfindung ist es, ein Verfahren zur digitalen Erzeugung von Steuerfrequenzen zu schaffen, bei dem unter Vermeidung ultrahoher Primärfrequenzen mit einfachem Gerät eine feinstufige Steuerfrequenzänderung $\Delta f$ erreichbar ist.

Diese Aufgabe wird bei einer Schaltungsanordnung der eingangs erwähnten Art gemäß der Erfindung durch die in Patentanspruch 1 angegebenen Maßnahmen gelöst. Danach wird zur Einstellung einer Steuerfrequenz von zumindest zwei Steuerfrequenzen, $f_0$ und $f_n$ ausgegangen, die durch ganzzahliges Unterteilen eines Frequenznormals erzeugt und innerhalb aufeinanderfolgender Perioden x in folgender Weise miteinander vermischt werden: Jede der Perioden x ist in Perioden $n_{f0}$ und $n_{fn}$ aufgeteilt, wobei

$$x = n_{f0} + n_{fn}$$

ist. Während der Periode $n_{f0}$ wird die Steuerfrequenz $f_0$, während der Periode $n_{fn}$ die Steuerfrequenz fn eingestellt, so daß sich über der Periode x eine mittlere Steuerfrequenz $\overline{f_{st}}$ von

$$\overline{f_{st}} = \frac{1}{x}(n_{f0} \cdot f_0 + n_{fn} \cdot f_n)$$

ergibt. Die mittlere Steuerfrequenz $\overline{f_s}$ ist somit durch entsprechende Bestimmung der Anzahl der Perioden $n_{f0}$ und $n_{fn}$ erreichbar. Die Frequenzen $f_0$ und $f_n$ unterscheiden sich voneinander dadurch, daß beim ganzzahligen Unterteilen eines Frequenznormals der Teiler jeweils um mindestens 1 geändert ist, wobei die Werte durch

$$f_0 < f_{st} < f_n$$

gegeben sind. Zur Änderung von Steuerfrequenzen wird die Steuerfrequenzänderung $\Delta f$ innerhalb einer ganzzahligen Periodenanzahl $x^2$ abgeschlossen, die in aufeinanderfolgende Periodengruppen $x_1$ bis $x_x$, beispielsweise in Periodengruppen $x_1$, $x_2$ bis $x_{10}$ aufgeteilt ist. Jede Periodengruppe enthält jeweils x Perioden der bereits vorbeschriebenen Art, wobei in jeder Periodengruppe x der eine Teil der Perioden $n_{f0}$ mit alter Frequenz, also der Ausgangsfrequenz $f_0$, der andere Teil der Perioden $n_{fn}$ mit der neuen Frequenz $f_n$ ($f_n = f_0 \pm \Delta f$) betrieben wird.

Es gilt somit stets

$$x(\text{von } x_1 \text{ bis } x_x) = n_{f0} + n_{fn}.$$

Die Anzahl der Perioden mit neuer und alter Frequenz wird nun von Periodengruppe zu Periodengruppe, also von $x_1$ bis $x_x$ so geändert, daß die Anzahl der Perioden mit neuer Frequenz $n_{fn}$ von $x_1$ bis $x_x$ um mindestens eine Periode zunimmt, während die Anzahl der Perioden mit alter Frequenz $n_{fn}$ von $x_1$ bis $x_x$ um mindestens eine Periode abnimmt. Es wird also gemäß der Erfindung nach Festlegung der Periodenanzahl $x^2$ in jeder Perio-

dengruppe $x_1$ bis $x_x$ von Periodengruppe zu Periodengruppe mindestens eine Periode mehr mit der neuen Frequenz $f_n$ und mindestens eine Periode weniger mit der alten Frequenz $f_n$ betrieben, so daß nach Durchlauf aller Perioden $x^2$ als neue Steuerfrequenz die Frequenz $f_n$ erreicht ist.

Dies bedeutet bespielsweise bei der Steuerung von Synchronmotoren, daß der Motor innerhalb der ersten Periodengruppe $x_1$ nur für eine einzelne Periode mit der neuen Drehfeldfrequenz $f_n$ beaufschlagt wird. Für alle anderen Perioden verbleibt es in der Periodengruppe $x_1$ bei der ursprünglichen Drehfrequenz $f_o$. In der nächsten Periodengruppe $x_2$ wird die Anzahl der Perioden $n_{fn}$ mit neuer Frequenz $f_n$ um 1 erhöht, so daß der Synchronmotor nunmehr zwei Perioden lang mit der neuen Steuerfrequenz $f_n$ beaufschlagt wird. Nach Ablauf jeder weiteren Periodengruppe $x$ erhöht sich die Periodenanzahl $n_{fn}$ um 1, so daß nach Ablauf der $x^2$ Perioden die neue Drehfeldfrequenz $f_n$ erreicht ist. Mit diesem Verfahren einer schrittweisen Annäherung an die neue Frequenz $f_n$ wird eine um den Faktor $x$ verkleinerte Steuerfrequenzänderung erreicht, die sich in gleicher Weise wie ein um dem Faktor $x$ erhöhtes Frequenznormal auswirkt.

In weiterer Ausbildung der Erfindung ist es vorgesehen, die Periodenanzahl $x^2$ in Abhängigkeit von der benötigten Steuerfrequenz $f_{st}$ festzulegen, Patentanspruch 3. Als zweckmäßig hat sich die Periodenanzahl $x^2 = k.f_{st}^3$ erwiesen, Patentanspruch 4. Dabei ist k ein Proportionalitätsfaktor, der dem jeweiligen technischen Anwendungsfall anpaßbar ist. So ist k beispielsweise bei der Steuerung von Drehzahlen proportional zur Ausgangsdrehzahl festzulegen. Die Periodenanzahl $x^2$ ist somit umso größer, je größer die Steuerfrequenz $f_{st}$ ist. Sie nimmt mit sich vergrößern-der Steuerfrequenzänderung $\Delta f$ zu und linearisiert quasi auf diese Weise die Änderung der Steuerfrequenz bei sich veränderndem Divisor. Eine Änderung des Frequenznormals ist nicht erforderlich.

Das erfindungsgemäße Verfahren und eine zur Durchführung des Verfahrens geeignete Schaltungsanordnung wird nachfolgend anhand von Ausführungsbeispielen näher erläutert. Die Zeichnung zeigt im einzelnen:

Fig. 1 Schaltungsanordnung;

Fig. 2 Ablauf der Frequenzänderung bei einer Änderung der Steuerfrequenz um $\Delta f$.

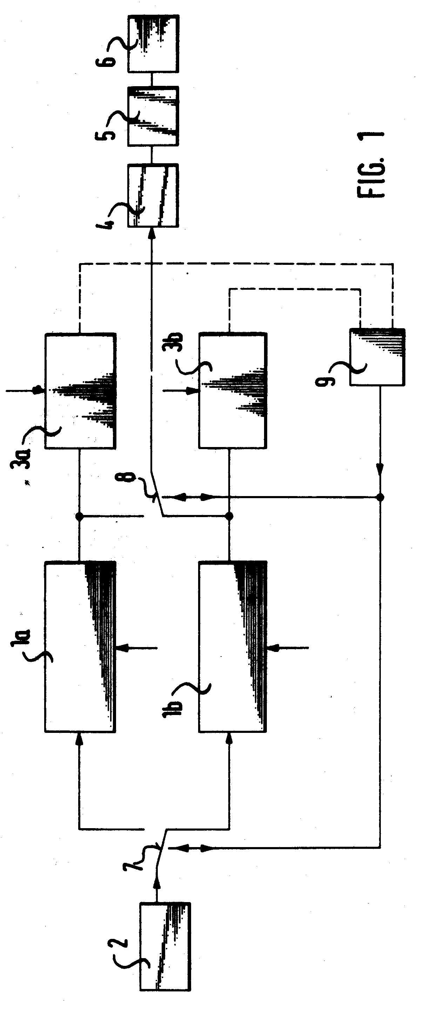

In Fig. 1 ist eine Schaltungsanordnung schematisch dargestellt. Mit Frequenzwandler 1a, 1b, deren Eingangsfrequenz von einem Frequenznormal 2 mit Primärfrequenz $f_q$ bestimmt ist, sind Rechnereinheiten 3a, 3b verbunden. Die Rechnereinheiten steuern die Frequenzwandler so, daß am Frequenzausgang 4 die Steuerfrequenz $f_{st}$ abgreifbar ist. Im Ausführungsbeispiel ist der Frequenzausgang mit einem Frequenzumformer 5 für Synchronmotoren 6 verbunden.

Als Frequenzwandler ist im Ausführungsbeispiel ein programmierbarer Zähler, Teiler-IC eingesetzt, als Rechnereinheit wird über einen entsprechenden BUS ein CPU-Glied (Control Prozessor Unit) verwendet.

Als erstes Anwendungsbeispiel wird zunächst eine Steuerfrequenzänderung beschrieben:

Von der Rechnereinheit 3a wird vom Frequenzwandler 1a die Ausgangsfrequenz $f_o$ abgegriffen und in Abhängigkeit davon die Periodenzahl $x^2 = k.f_{st}^3$ mit $f_{st} = f_o$ betimmt. Die neue, um eine Zählereinheit des Divisors geänderte Steuerfrequenz $f_n$ wird über den Frequenzwandler 1b eingestellt. Sie ist von der Rechnereinheit 3b abgreifbar.

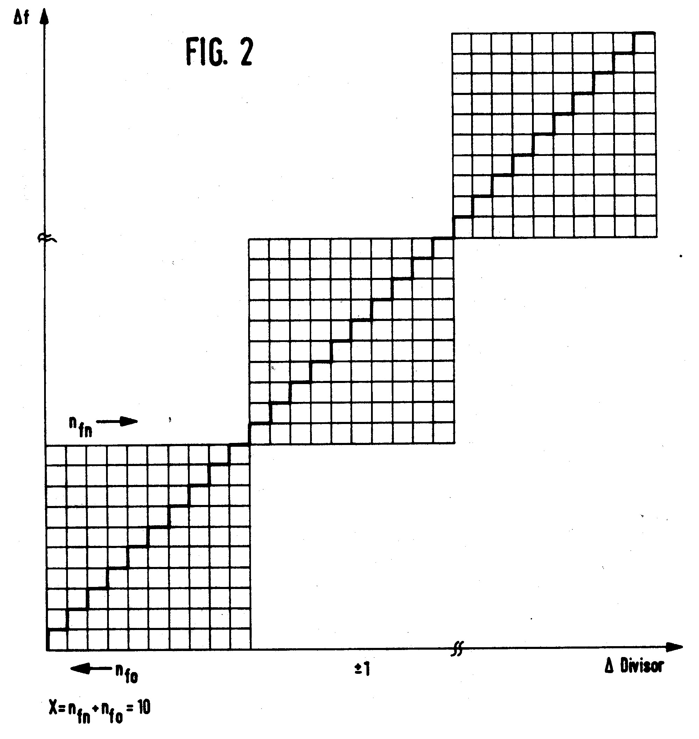

Zur Einstellung der neuen Steuerfrequenz $f_n$ werden nun dem Frequenzausgang 4 von der Rechnereinheiten innerhalb einer Periodenzahl $x = n_{fo} + n_{fn}$ entweder die Ausgangsfrequenz fo oder die neue Steuerfrequenz fn aufgeschaltet. Dabei wird in jeder Periodengruppe $x_1$ bis $x_x$ die Anzahl der Perioden mit neuer Frequenz $n_{fn}$ jeweils um 1 erhöht und die Anzahl der Perioden mit alter Frequenz $n_{fo}$ jeweils um 1 vermindert. Zur Umschaltung sind Umschalter 7, 8 vorgesehen. Ist die Ausgangsfrequenz fo abzugreifen, ist das Frequenznormal 2 über den Umschalter 7 mit Frequenzwandler 1a und Rechnereinheit 3a verbunden und Umschalter 8 verbindet den Frequenzwandler 1a mit dem Frequenzausgang 4. In Fig. 2 ist der Umschalter 7 mit Frequenzwandler 1b verbunden und über Umschalter 8 liegt die Steuerfrequenz fn aus Frequenzausgang 4 an. Die Rechnereinheit 3b schaltet über ein Zählwerk 9 am Ende jeder Periodengruppe $x$ die Umschalter 7 und 8 zurück, so daß vom Frequenzausgang erneut die Ausgangsfrequenz fo abgegeben wird.

Der Ablauf der Frequenzänderung innerhalb der Periodenanzahl $x^2$ bei einer Änderung der Steuerfrequenz um $\Delta f$ ist Fig. 2 entnehmbar. Dabei wird davon ausgegangen, daß am Teiler-IC als Frequenznormal ein Quarznormal mit einer Primärfrequenz $f_q$ von 9 Mhz anliegt und daß als Ausgangsfrequenz fo eine Steuerfrequenz $f_{st}$ von 1200 hz benötigt wird, um eine Drehfrequenz von 100 hz zu erhalten. Zur Festsetzung der Periodenanzahl $x^2$, innerhalb der eine Änderung der Steuerfrequenz bei ganzzahliger Veränderung des Divisors um 1 erfolgen soll, wird als Konstante $k_\alpha = 10.10^{-5}$ festgelegt. Für $x^2$ ergibt sich somit aus $x^2 = k.f_{st}^3 = k_\alpha . f_\alpha^3 = 100$ für $x = 10$.

Im Anwendungsbeispiel ist also die neue Steuerfrequenz $f_n$ nach Ablauf von 100 Perioden erreicht und - da jede Periodengruppe $x$ aus jeweils 10 Perioden besteht - sind zur Steuerfrequenzänderung $\Delta f$ 10 Periodengruppen erforderlich. Es erhöht sich dabei in jeder Periodengruppe $x_1$ bis $x_{10}$

die Anzahl der Perioden mit neuer Frequenz $n_{fn}$ von 1 bis 10 jeweils um 1, während die Anzahl der Perioden $n_{fo}$, die noch die Ausgangsfrequenz $f_o$ aufweisen, in jeder der Periodengruppen $x_1$ bis $x_{10}$ von 9 auf 0 jeweils um 1 verringert wird.

In Fig. 2 ist die Frequenzänderung für drei Steuerfrequenzänderungen $\Delta f$ dargestellt, die sich bei ganzzahliger Teilung des Frequenznormals und Änderung des Divisors um 1 ergeben. In allen drei Fällen ist die Änderung der Steuerfrequenz $\Delta f$ nach Ablauf von 100 Perioden abgeschlossen, wobei $x = n_{fn} + n_{fo} = 10$ beträgt.

Geht man von der Eingangsfrequenz des Teiler-IC's, vom Frequenznormal von 9 Mhz aus, so ergibt sich für die benötigte Steuerfrequenz $f_{st}$ von 1200 hz ein Divisor von 7500. Ändert sich dieser Divisor um 1, so ergibt sich eine Steuerfrequenzänderung $\Delta f$ um 0,16 hz. Gemäß der Erfindung wird jedoch innerhalb einer Periodengruppe $x$ von 10 Perioden jeweils gegenüber der vorhergehenden Periodengruppe nur eine der Perioden geändert. Das bedeutet, daß sich die insgesamt erforderliche Änderung um das 10fache streckt und somit eine Steuerfrequenzänderung erreicht wird, die sich sonst nur bei einem um 10fach höheren Frequenznormal ergibt. Durch Veränderung des Faktors $k$ läßt sich die Periodenanzahl, innerhalb der die Steuerfrequenzänderung $\Delta f$ vollzogen sein muß, den gegebenen technischen Erfordernissen noch anpassen. Es wird zwar mit einer Veränderung des Proportionalitätsfaktors $k$ auch die Zeit geändert, innerhalb der die Steuerfrequenzänderung vollzogen ist. Daraus folgt aber im Anwendungsbeispiel auch ein entsprechend umgekehrt proportionales Anpassen der Drehfeldfrequenz an die erforderliche Drehzahl des Synchronmotors.

Die Erfindung ist auf die Anwendung zur Steuerung von Synchronmotoren nicht beschränkt. Sie ist überall dort von Vorteil, wo große Steuerungsfrequenzsprünge allmählich, insbesondere linear vollzogen werden müssen. Statt einer linearen Änderung sind auch andere Steuerfrequenzänderungen erreichbar. So ist es durchaus möglich, von Periodengruppe zu Periodengruppe die Anzahl der Perioden mit neuer Frequenz $n_{fn}$ in anderer Weise als um 1 zu verändern, beispielsweise dadurch, daß sich $n_{fn}$ von einer Periodengruppe zur anderen in folgender Reihenfolge verändert: 1, 3, 6, 10. Die Steuerfrequenzänderung $\Delta f$ wäre dann bereits nach vier Periodengruppen $x_1$ bis $x_4$ abgeschlossen.

Die in Fig. 1 wiedergegebene Schaltungsanordnung ist selbstverständlich auch zur Erzeugung von Zwischenfrequenzen über längere Zeiträume einsetzbar. Zu diesem Zweck ist von den Rechnereinheiten von Periodengruppe zu Periodengruppe keine Änderung der Anzahl der Frequenzen fo und fn mehr vorgesehen, es wird vielmehr in jeder Periodengruppe $n_{fo}$ und $n_{fn}$ konstant gehalten, so daß sich als Zwischenfrequenz am Frequenzausgang die mittlere Steuerfrequenz

$$\overline{f_{st}} = \tfrac{1}{x}(n_{fo} \cdot f_o + n_{fn} \cdot fn)$$

ergibt. Ist beispielsweise bei einem Frequenznormal $f_q = 9$ Mhz anstelle einer Steuerfrequenz von 6000 hz eine Steuerfrequenz von 5998,8 hz einzustellen, so sind der Divisor des Frequenzwandlers 1a = 1500, der Divisor des Frequenzwandlers 1b = 1501 zu wählen und die Frequenzwandler 1a, 1b so zu schalten, daß der Frequenzausgang innerhalb von 10 Perioden jeweils 7 Perioden lang ($n_{fo} = 7$) mit der Steuerfrequenz fo = 600 hz und 3 Perioden lang ($n_{fn} = 3$) mit der Steuerfrequenz $f_n = 5996$ hz beaufschlagt wird. Man erhält dann als mittlere Steuerfrequenz mit

$$\overline{f_{st}} = \tfrac{1}{10}(7 \cdot 6000 + 3 \cdot 5996) = 5998,8 \text{ hz}$$

die gewünschte Steuerfrequenz.

**Patentansprüche**

1. Schaltungsanordnung zur digitalen Einstellung einer Steuerfrequenz durch ganzzahliges Unterteilen eines Frequenznormals, insbesondere eines durch Erregung eines Schwingquarzes erzeugten Frequenznormals (2), mittels eines rechnergesteuerten Frequenzwandlers (1a, 1b), an dessen Ausgang zumindest zwei Steuerfrequenzen, fo und fn, abgreifbar sind, die innerhalb einer Periodengruppe $x_0$ mit $x$ Perioden in der Weise miteinander gemischt werden, daß ein Teil der Perioden $n_{f0}$ mit der Steuerfrequenz fo, der andere Teil der Perioden $n_{fn}$ mit der Steuerfrequenz $f_n$ betrieben wird, und daß in jeder Periodengruppe $x_0$ für die $x$ Perioden $x = n_{fn} + n_{f0}$ gilt,
**dadurch gekennzeichnet,**
daß innerhalb einer Periodenanzahl $x^2$ eine Steuerfrequenzänderung erfolgt, wobei die $x^2$ Perioden in Periodengruppen $x_1$ bis $x_x$ mit jeweils $x$ Perioden aufgeteilt sind, und daß von der Periodengruppe $x_1$ bis zur Periodengruppe $x_x$ aufeinanderfolgend jeweils der Teil der Perioden $n_{fn}$ um mindestens eine Periode erhöht und der Teil der Perioden $n_{f0}$ um mindestens eine Periode vermindert wird, so daß nach Ablauf der Periodenanzahl $x^2$ alle Perioden die Frequenz $f_n$ aufweisen.

2. Schaltungsanordnung nach Patentanspruch 1,
**dadurch gekennzeichnet,**
daß die Periodenanzahl $x^2$ von der benötigten Steuerfrequenz $f_{st}$ abhängig ist.

**3.** Schaltungsanordnung nach Patentanspruch 2, **dadurch gekennzeichnet,** daß die Periodenanzahl $x^2$ durch

$$x^2 = k \cdot f_{st}^3$$

bestimmt ist, wobei k ein Proportionalitätsfaktor ist.

## Claims

**1.** A circuit arrangement for the digital tuning of a control frequency by the integral subdivision of a frequency standard, particularly a frequency standard (2) produced by the excitation of a quartz resonator, by means of a computer-controlled frequency transformer (1a, 1b) at the output of which at least two control frequencies, fo and fn, can be tapped, which are mixed with each other within a group of cycles $x_0$ with x cycles in such a way that one part of the cycle: $n_{f0}$ is operated with the control frequency $f_0$ and the other part of the cycles $n_{fn}$ is operated with the control frequency $f_n$, and that $x = n_{fn} + n_{f0}$ is valid for the x cycles in each group of cycles $x_0$, characterised in that a control frequency alteration occurs within a number of cycles $x^2$, wherein the $x^2$ cycles in groups of cycles $x_1$ to $x_x$ are each divided into x cycles, and that, from the group of cycles $x_1$ to the group of cycles $x_x$ successively, the part of the cycles $n_{fn}$ increases by at least one cycle, and the part of the cycles $n_{f0}$ decreases by at least one cycle, so that after the number of cycles $x^2$ has been completed all cycles have the frequency $f_n$.

**2.** A circuit arrangement according to Claim 1, characterised in that the number of cycles $x^2$ is dependent on the required control frequency $f_{st}$.

**3.** A circuit arrangement according to Claim 2, characterised in that the number of cycles $x^2$ is given by

$$x^2 = k \cdot f_{st}^3,$$

where k is a proportionality factor.

## Revendications

**1.** Montage pour régler numériquement une fréquence de commande au moyen d'une division, par un nombre entier, d'une fréquence étalon, notamment d'une fréquence étalon (2) produite par excitation d'un quarts oscillateur, au moyen d'un convertisseur de fréquence (1a,1b) commandé par un calculateur et à la sortie duquel on peut prélever au moins deux fréquences de commande, fo et fn, que l'on mélange l'une à l'autre pendant un groupe de périodes $x_0$ comportant x périodes de manière que pour une partie des périodes $n_{f0}$, on travaille avec la fréquence de commande $f_0$ et que pour l'autre partie des périodes $n_{fn}$, on travaille avec la fréquence de commande $f_n$ et que dans chaque groupe de périodes $x_0$ on a, pour les x périodes, $x = n_{fn} + n_{f0}$, caractérisé par le fait que pendant un nombre de périodes $x^2$ est exécutée une modification de la fréquence de commande, les $x^2$ périodes étant réparties en des groupes de périodes $x_1$ à $x_x$ possédant chacun x périodes, et que successivement, du groupe de périodes $x_1$ au groupe de périodes $x_x$, respectivement une partie des périodes $n_{fn}$ est accrue au moins d'une période et la partie des périodes $n_{f0}$ est réduite d'au moins une période de sorte qu'après le déroulement du nombre $x^2$ de périodes, toutes les périodes possèdent la fréquence $f_n$.

**2.** Montage suivant la revendication 1, caractérisé par le fait que le nombre $x^2$ de périodes dépend de la fréquence nécessaire de commande $f_{st}$.

**3.** Montage suivant la revendication 2, caractérisé par le fait que le nombre $x^2$ de périodes est déterminé par

$$x^2 = k \cdot fst^3$$

k étant un facteur de proportionnalité.

FIG. 1

FIG. 2